(19) Europäisches Patentamt
European Patent Office
Office européen des brevets

(11) **EP 4 439 979 A1**

(12) **EUROPEAN PATENT APPLICATION**

(43) Date of publication:
**02.10.2024 Bulletin 2024/40**

(21) Application number: **24163199.3**

(22) Date of filing: **13.03.2024**

(51) International Patent Classification (IPC):
**H03F 1/14** (2006.01) **H03F 3/187** (2006.01)
**H03F 3/21** (2006.01)

(52) Cooperative Patent Classification (CPC):
**H03F 3/187; H03F 1/14; H03F 3/211;**
H03F 2200/03; H03F 2200/135; H03F 2200/153;
H03F 2200/297

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.03.2023 US 202363489790 P
06.02.2024 US 202418433468**

(71) Applicant: **MediaTek Inc.
Hsin-Chu 300 (TW)**

(72) Inventors:
• **CHEN, You-Shin
30078 Hsinchu City (TW)**
• **CHEN, Ya-Chi
30078 Hsinchu City (TW)**
• **WEN, Sung-Han
30078 Hsinchu City (TW)**

(74) Representative: **Haseltine Lake Kempner LLP
Cheapside House
138 Cheapside
London EC2V 6BJ (GB)**

(54) **AREA-EFFICIENT COMPENSATION CIRCUIT FOR LOW-POWER MULTI-STAGE AMPLIFIER**

(57)     The present invention provides a multi-stage amplifier, wherein the multi-stage amplifier includes a plurality of amplifier stages and a compensation circuit. The compensation circuit is coupled to an output terminal of one of the plurality of amplifier stages, and the compensation circuit includes a first auxiliary amplifier, a capacitor, a second auxiliary amplifier, a first resistor and a second resistor. The capacitor is coupled between an input terminal and an output terminal of the first auxiliary amplifier. The second auxiliary amplifier is coupled to the first auxiliary amplifier. The first resistor is coupled between an input terminal and an output terminal of the second auxiliary amplifier. The second resistor is coupled between an output terminal of the first auxiliary amplifier and a ground voltage.

FIG. 1

Processed by Luminess, 75001 PARIS (FR)

**Description**

This application claims the benefit of U.S. Provisional Application No. 63/489,790, filed on March 13th, 2023. The content of the application is incorporated herein by reference.

Background

In order to damp high-frequency oscillations that might occur in the absence of loads in a loud speaker, a Zobel network having a resistor and a capacitor connected in series is usually placed on an output node of an audio amplifier of the loud speaker. However, the audio amplifier may be unstable due to the Zobel network if a bias current and a loop gain of output amplifier stage are reduced for a low power mode.

Summary

It is therefore an objective of the present invention to provide a multi-stage amplifier, which has a compensation circuit to provide a zero at low frequency to compensate a phase dip generated due to the Zobel network, to solve the above-mentioned problems.

According to one embodiment of the present invention, a multi-stage amplifier comprises a plurality of amplifier stages and a compensation circuit. The compensation circuit is coupled to an output terminal of one of the plurality of amplifier stages, and the compensation circuit comprises a first auxiliary amplifier, a capacitor, a second auxiliary amplifier, a first resistor and a second resistor. The capacitor is coupled between an input terminal and an output terminal of the first auxiliary amplifier. The second auxiliary amplifier is coupled to the first auxiliary amplifier. The first resistor is coupled between an input terminal and an output terminal of the second auxiliary amplifier. The second resistor is coupled between an output terminal of the first auxiliary amplifier and a ground voltage.

These and other objectives of the present invention will no doubt become obvious to those of ordinary skill in the art after reading the following detailed description of the preferred embodiment that is illustrated in the various figures and drawings.

Brief Description of the Drawings

    FIG. 1 is a diagram illustrating a multi-stage amplifier according to one embodiment of the present invention.
    FIG. 2 shows a gain and a phase contributed by the compensation circuit according to one embodiment of the present invention.
    FIG. 3 shows the phase compensation provided by using the compensation circuit.
    FIG. 4 is a diagram illustrating the second amplifier stage, the compensation circuit and the reference circuit according to a first embodiment of the present invention.
    FIG. 5 is a diagram illustrating the second amplifier stage, the compensation circuit and the reference circuit according to a second embodiment of the present invention.
    FIG. 6 is a diagram illustrating the second amplifier stage, the compensation circuit and the reference circuit according to a third embodiment of the present invention.
    FIG. 7 is a diagram illustrating the second amplifier stage, the compensation circuit and the reference circuit according to a fourth embodiment of the present invention.
    FIG. 8 is a diagram illustrating a multi-stage amplifier according to one embodiment of the present invention.

Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

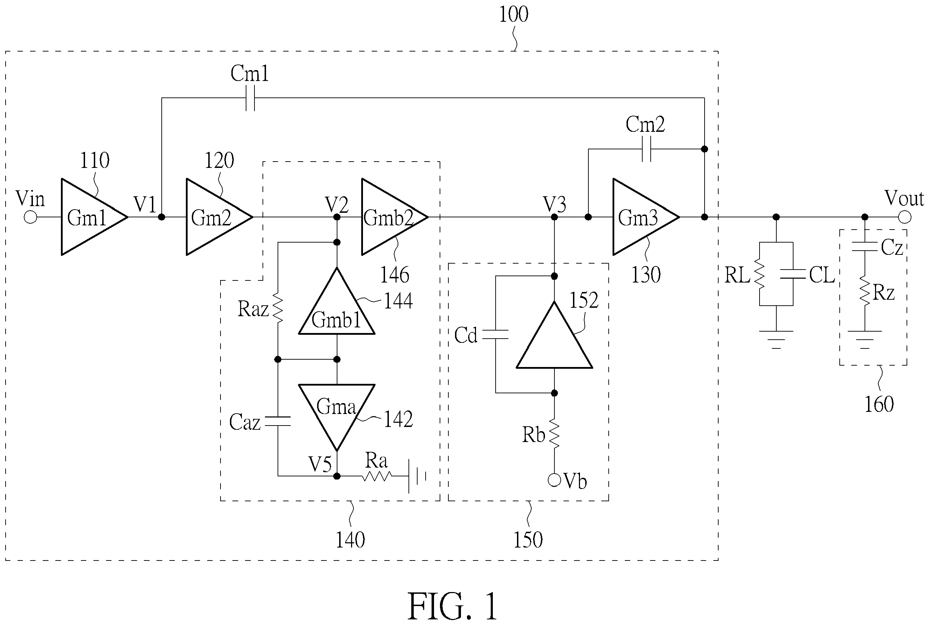

FIG. 1 is a diagram illustrating a multi-stage amplifier 100 according to one embodiment of the present invention. As shown in FIG. 1, the multi-stage amplifier 100 comprises a plurality of amplifier stages such as a first amplifier stage 110, a second amplifier stage 120 and a third amplifier stage 130, a compensation circuit 140, a reference circuit 150, a first feedback capacitor Cm1 and a second feedback circuit Cm2, wherein the first feedback capacitor Cm1 is coupled between an output terminal of the third amplifier stage 130 and an output terminal of the first amplifier stage 110, and the second feedback capacitor Cm2 is coupled between the output terminal of the third amplifier stage 130 and an input terminal of the third amplifier stage 130. In this embodiment, the multi-stage amplifier 100 serves as an audio amplifier in a loud speaker, wherein a resistor RL and a capacitor CL shown in FIG. 1 are used to represent a load of the multi-stage amplifier 100, and a damping circuit such as a Zobel network 160 comprising a capacitor Cz and a resistor Rz connected in series is coupled to an output node of the multi-stage amplifier 100 to damp high-frequency oscillations that might occur in the absence of loads in the loud speaker.

The compensation circuit 140 comprises a first auxiliary amplifier 142, a second auxiliary amplifier 144, a third auxiliary amplifier 146, a resistor Ra, a resistor Raz and a capacitor Caz. An input terminal of the first auxiliary amplifier 142 is coupled to a first node of the capacitor Caz, and an output terminal of the first auxiliary amplifier 142 is coupled to a second node of the capacitor Caz, that is the capacitor Caz is coupled between the input terminal and the output terminal of the first auxiliary amplifier 142. The resistor Raz is coupled between the output terminal of the first auxiliary amplifier 142 and a ground voltage. An input terminal of the second auxiliary amplifier 144 is coupled to the input terminal of the first auxiliary amplifier 142, and an output terminal of the second auxiliary amplifier 144 is coupled to an output terminal of the second amplifier stage 120. The resistor Raz is coupled between the input terminal and the output terminal of the second auxiliary amplifier 144. The third auxiliary amplifier 146 has an input terminal coupled to an output terminal of the second amplifier stage 120, and has an output terminal coupled to the input terminal of the third amplifier stage 130. In addition, the symbols "Gma", "Gmb1" and "Gmb2" are used to represent the gains of the first auxiliary amplifier 142, the second auxiliary amplifier 144 and the third auxiliary amplifier 146, respectively.

The reference circuit 150 comprises an amplifier 152, a resistor Rb and a capacitor Cd. An input terminal of the amplifier 152 is coupled to a bias voltage Vb via the resistor Rb, and an output terminal of the amplifier 152 is coupled to the input terminal of the third amplifier stage 130. The capacitor Cd is coupled between the input terminal and the output terminal of the amplifier 152. In addition, the symbol "Gd2" is used to represent the gain of the amplifier 152.

In the operation of the multi-stage amplifier 100, the first amplifier stage 110 receives an input signal Vin (audio signal) to generate a first signal V1, and the second amplifier stage 120 receives the first signal to generate a second signal V2, the compensation circuit 140 processes the second signal V2 to generate a third signal V3, and the third amplifier stage 130 receives the third signal V3 to generate an output signal Vout. In the embodiment shown in FIG. 1, each of the first amplifier stage 110, the second amplifier stage 120 and the third amplifier stage 130 can be implemented by any suitable amplifier, the symbols "Gm1", "Gm2" and "Gm3" are used to represent gains of the first amplifier stage 110, the second amplifier stage 120 and the third amplifier stage 130, respectively. Because the amplifier stages used in the loud speaker are known by a person skilled in the art, the detailed circuits of these amplifier stages are omitted here.

As described in the background of the present invention, the multi-stage amplifier may be unstable if a bias current and a loop gain are reduced for a low power mode. In order to solve this problem, the multi-stage amplifier 100 shown in FIG. 1 uses the compensation circuit 140 to provide a zero at low frequency to compensate the gain droop and phase dip, to increase a phase margin and stabilize the multi-stage amplifier 100.

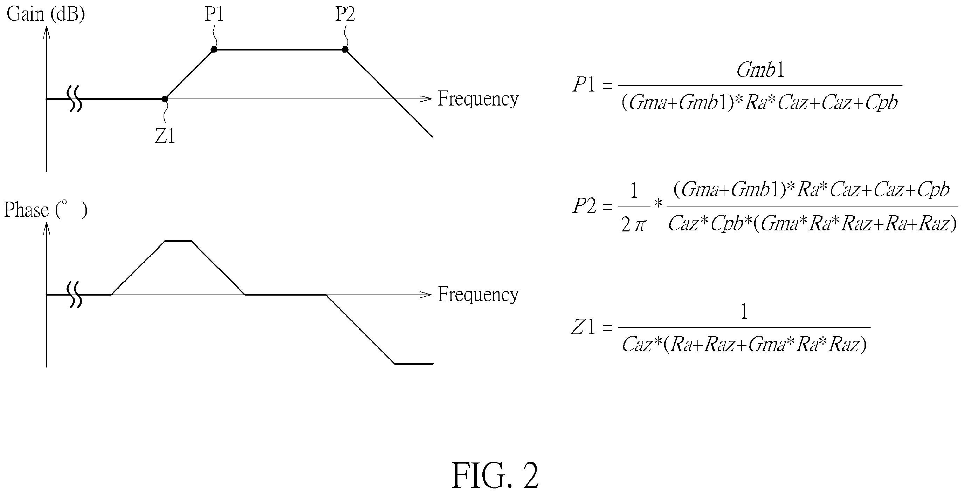

FIG. 2 shows a gain and a phase contributed by the compensation circuit 140 according to one embodiment of the present invention. As shown in FIG. 2, the first auxiliary amplifier 142, the second auxiliary amplifier 144, the capacitor Caz, and the resistors Ra and Raz are used to provide two poles and one zero for the transfer function of the multi-stage amplifier 100. Assuming that the first auxiliary amplifier 142 is a transconductance amplifier having a gain "Gma", and the second auxiliary amplifier 144 is a transconductance amplifier having a gain "Gmb1", frequencies of a first pole P1, a second pole P2 and a zero Z1 are as follows:

$$P1 = \frac{Gmb1}{(Gma + Gmb1)*Ra*Caz + Caz + Cpb} \quad \dots\dots\dots\dots\dots\dots\dots\dots\dots \text{(1)};$$

$$P2 = \frac{1}{2\pi} * \frac{(Gma + Gmb1)*Ra*Caz + Caz + Cpb}{Caz*Cpb*(Gma*Ra*Raz + Ra + Raz)} \quad \dots\dots\dots\dots\dots\dots \text{(2)};$$

$$Z1 = \frac{1}{Caz*(Ra + Raz + Gma*Ra*Raz)} \quad \dots\dots\dots\dots\dots\dots\dots \text{(3)};$$

wherein the symbol "Cpb" is an equivalent capacitance between the output terminal of the second auxiliary amplifier 144 and the ground voltage.

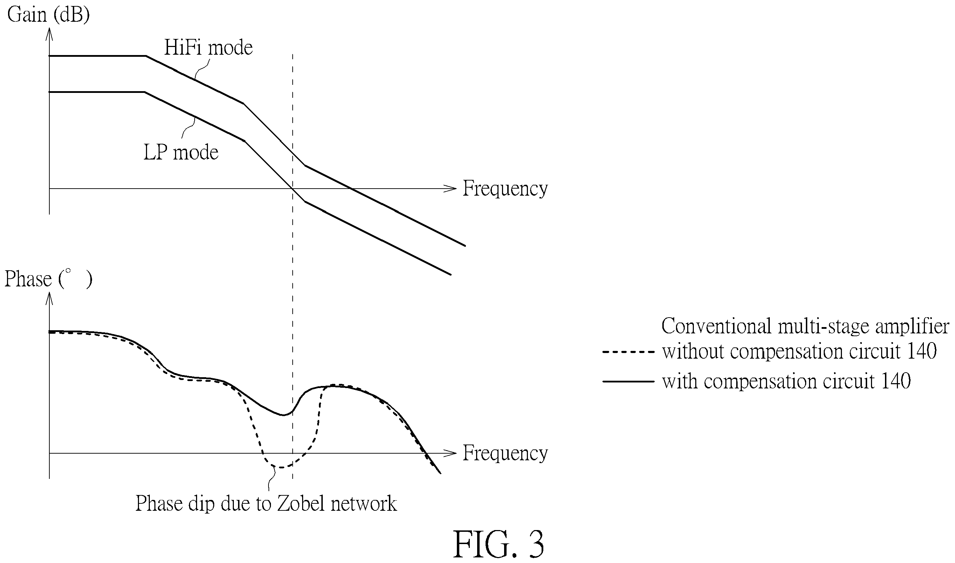

Refer to FIG. 2 and FIG. 3 together, wherein FIG. 3 shows the phase compensation provided by using the compensation circuit 140. As shown in FIG. 2 and FIG. 3, the multi-stage amplifier 100 can selectively operate in a high-fidelity mode (HiFi mode) or a low-power mode (LP mode). In the conventional multi-stage amplifier without the compensation circuit 140, when the low-power mode is performed, the phase dip occurs at a frequency whose gain is 0dB (i.e., unity-gain frequency) due to the Zobel network 160. In addition, by using the compensation circuit 140 in the multi-stage amplifier 100, the zero Z1 is generated at low frequency to provide positive phase trapezoid to compensate the phase dip, so that the phase margin will be increased at these frequencies to stabilize the multi-stage amplifier 100.

In addition, by using the active device (i.e., the first auxiliary amplifier 142) and the resistor Ra in the compensation circuit 140 to increase the impact of resistor Raz and the capacitor Caz on the zero point in the above equation (3), the resistor Raz and the capacitor Caz can be designed with smaller size to lower the manufacturing costs. Specifically, referring to the denominator of the equation (3), the denominator is dominated by "Caz*Gma*Ra*Raz", so if "Gma*Ra" is designed to have higher value by using active device, the "Caz*Raz" can be a smaller value, that is the chip area of the resistor Raz and the capacitor Caz can be smaller.

It is noted that, in the embodiment shown in FIG. 1, the third auxiliary amplifier 146 within the compensation circuit 140 and the reference circuit 150 can be removed from the multi-stage amplifier 100. That is, the third amplifier stage 130 can directly receive the second signal V2 to generate the output signal Vout. This alternative design shall fall within the scope of the present invention.

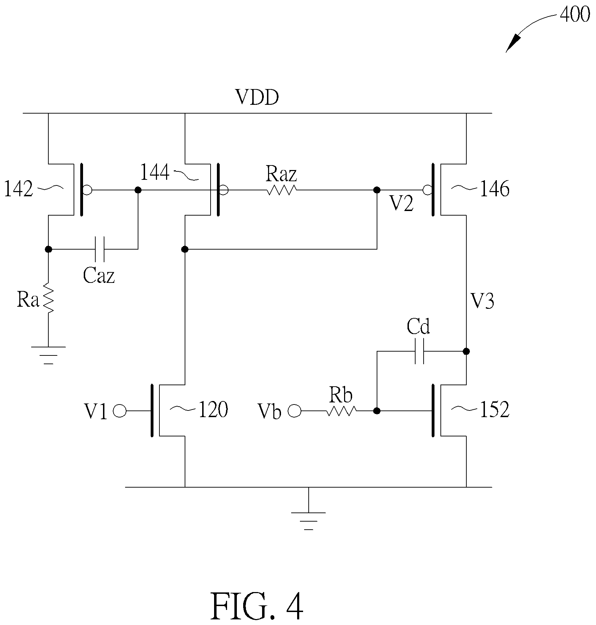

FIG. 4 is a diagram illustrating the second amplifier stage 120, the compensation circuit 140 and the reference circuit 150 according to a first embodiment of the present invention. In this embodiment, the second amplifier stage 120 is implemented by an N-type Metal Oxide Semiconductor Field Effect Transistor (MOSFET), the first auxiliary amplifier 142 is implemented by a P-type MOSFET, the second auxiliary amplifier 144 is implemented by a P-type MOSFET, and the amplifier 152 within the reference circuit 150 is implemented by an N-type MOSFET.

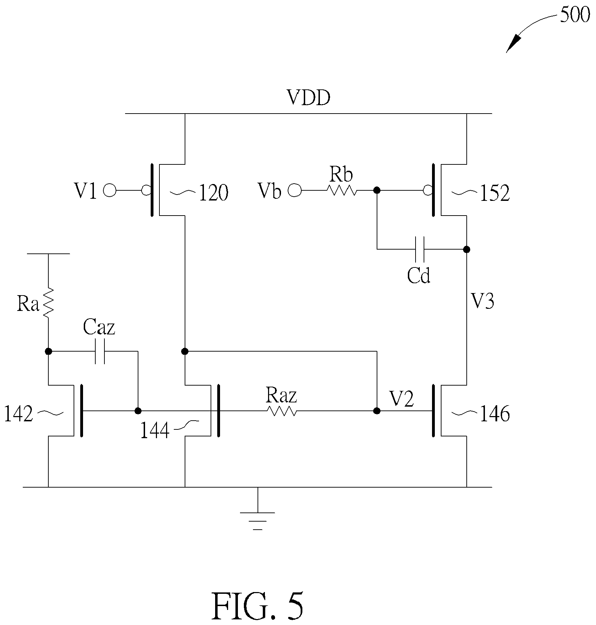

FIG. 5 is a diagram illustrating the second amplifier stage 120, the compensation circuit 140 and the reference circuit 150 according to a second embodiment of the present invention. In this embodiment, the second amplifier stage 120 is implemented by a P-type MOSFET, the first auxiliary amplifier 142 is implemented by an N-type MOSFET, the second auxiliary amplifier 144 is implemented by an N-type MOSFET, and the amplifier 152 within the reference circuit 150 is implemented by a P-type MOSFET.

In addition, in the embodiments shown in FIG. 4 and FIG. 5, the resistor Ra can be implemented by using a P-type MOSFET or an N-type MOSFET.

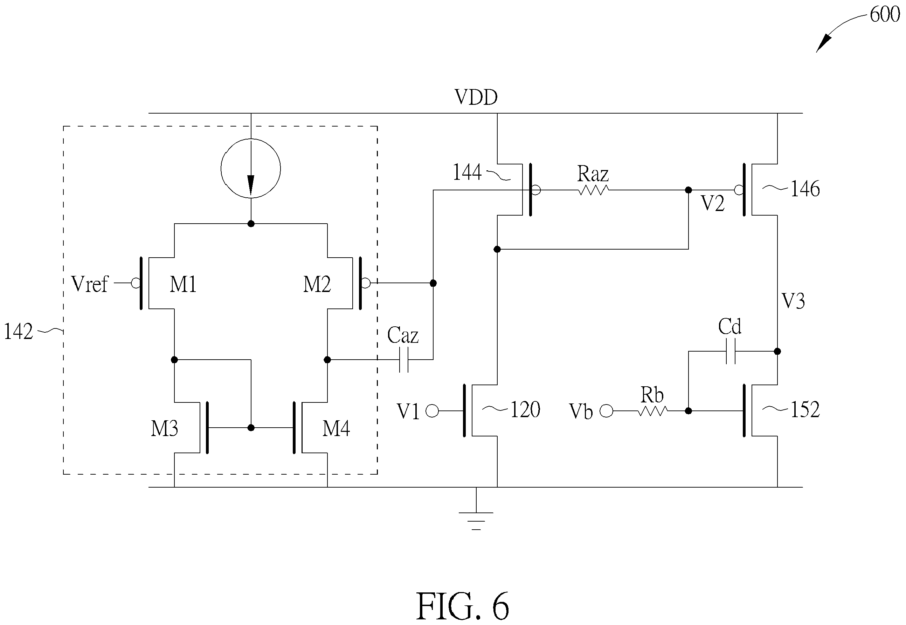

FIG. 6 is a diagram illustrating the second amplifier stage 120, the compensation circuit 140 and the reference circuit 150 according to a third embodiment of the present invention. In this embodiment, the second amplifier stage 120 is implemented by an N-type MOSFET, the first auxiliary amplifier 142 and the resistor Ra are implemented by a differential amplifier comprising transistors M1-M4 and a current source (Vref shown in FIG. 6 is a reference voltage), the second auxiliary amplifier 144 is implemented by a P-type MOSFET, and the amplifier 152 within the reference circuit 150 is implemented by an N-type MOSFET.

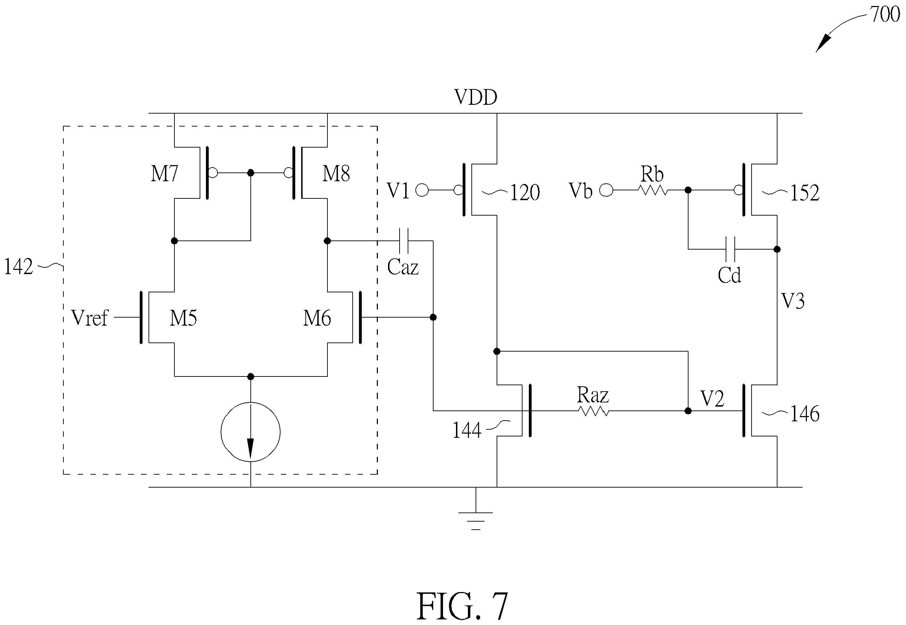

FIG. 7 is a diagram illustrating the second amplifier stage 120, the compensation circuit 140 and the reference circuit 150 according to a second embodiment of the present invention. In this embodiment, the second amplifier stage 120 is implemented by a P-type MOSFET, the first auxiliary amplifier 142 and the resistor Ra are implemented by a differential amplifier comprising transistors M5-M8 and a current source (Vref shown in FIG. 7 is a reference voltage), the second auxiliary amplifier 144 is implemented by an N-type MOSFET, and the amplifier 152 within the reference circuit 150 is implemented by a P-type MOSFET.

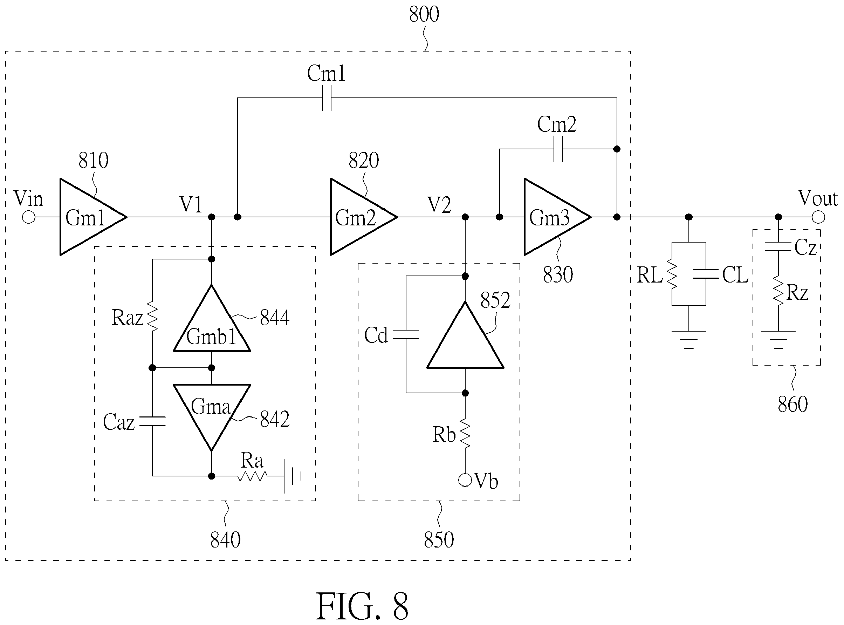

FIG. 8 is a diagram illustrating a multi-stage amplifier 800 according to one embodiment of the present invention. As shown in FIG. 8, the multi-stage amplifier 800 comprises a plurality of amplifier stages such as a first amplifier stage 810, a second amplifier stage 820 and a third amplifier stage 830, a compensation circuit 840, a reference circuit 850, a first feedback capacitor Cm1 and a second feedback circuit Cm2, wherein the first feedback capacitor Cm1 is coupled between an output terminal of the third amplifier stage 830 and an output terminal of the first amplifier stage 810, and the second feedback capacitor Cm2 is coupled between the output terminal of the third amplifier stage 830 and an input terminal of the third amplifier stage 830. In this embodiment, the multi-stage amplifier 800 is used to implement an output stage of a loud speaker, wherein a resistor RL and a capacitor CL shown in FIG. 8 are used to represent a load of the multi-stage amplifier 800, and a Zobel network comprising a capacitor Cz and a resistor Rz connected in series is coupled to an output node of the multi-stage amplifier 800 to damp high-frequency oscillations that might occur in the absence of loads in the loud speaker.

The compensation circuit 840 comprises a first auxiliary amplifier 842, a second auxiliary amplifier 844, a resistor Ra, a resistor Raz and a capacitor Caz. An input terminal of the first auxiliary amplifier 842 is coupled to a first node of the capacitor Caz, and an output terminal of the first auxiliary amplifier 842 is coupled to a second node of the capacitor Caz. The resistor Raz is coupled between the output terminal of the first auxiliary amplifier 842 and a ground voltage. An input terminal of the second auxiliary amplifier 844 is coupled to the input terminal of the first auxiliary amplifier 842, and an output terminal of the second auxiliary amplifier 844 is coupled to an output terminal of the first amplifier stage 810. The resistor Raz is coupled between the input terminal and the output terminal of the second auxiliary amplifier 844. In addition, the symbols "Gma" and "Gmb1" are used to represent the gains of the first auxiliary amplifier 842 and the second auxiliary amplifier 844, respectively.

The reference circuit 850 comprises an amplifier 852, a resistor Rb and a capacitor Cd. An input terminal of the amplifier 852 is coupled to a bias voltage Vb via the resistor Rb, and an output terminal of the amplifier 852 is coupled to the input terminal of the third amplifier stage 830. The capacitor Cd is coupled between the input terminal and the output terminal of the amplifier 852. In addition, the symbol "Gd2" is used to represent the gain of the amplifier 852.

In the operation of the multi-stage amplifier 800, the first amplifier stage 810 receives an input signal Vin to generate a first signal V1, and the second amplifier stage 820 receives the first signal to generate a second signal V2, and the third amplifier stage 830 receives the second signal V2 to generate an output signal Vout. In the embodiment shown in FIG. 8, each of the first amplifier stage 810, the second amplifier stage 820 and the third amplifier stage 830 can be implemented by any suitable amplifier, the symbols "Gm1", "Gm2" and "Gm3" are used to represent gains of the first amplifier stage 810, the second amplifier stage 820 and the third amplifier stage 830, respectively. Because the amplifier stages used in the loud speaker are known by a person skilled in the art, the detailed circuits of these amplifier stages are omitted here.

Similar to the embodiment shown in FIG. 1, FIG. 2 and FIG. 3, by using the compensation circuit 840 in the multi-stage amplifier 800, the zero Z1 is generated at low frequency to provide positive phase trapezoid to compensate the phase dip generated due to the Zobel network 860, so that the phase margin will be increased to stabilize the multi-stage amplifier 800. In addition, by using the first auxiliary amplifier 842 and the resistor Ra in the compensation circuit 840 to increase the impact of resistor Raz and the capacitor Caz on the zero point in the above equation (3), the resistor Raz and the capacitor Caz can be designed with smaller size to lower the manufacturing costs.

Those skilled in the art will readily observe that numerous modifications and alterations of the device and method may be made while retaining the teachings of the invention. Accordingly, the above disclosure should be construed as limited only by the metes and bounds of the appended claims.

**Claims**

1. A multi-stage amplifier (100, 800), comprising:

    a plurality of amplifier stages (110, 120, 130, 810, 820, 830); and
    a compensation circuit (140, 840), coupled to an output terminal of one of the plurality of amplifier stages (110, 120, 130, 810, 820, 830), wherein the compensation circuit (140, 840) comprises:

        a first auxiliary amplifier (142, 842);
        a capacitor, wherein the capacitor (Caz) is coupled between an input terminal and an output terminal of the first auxiliary amplifier (142, 842);
        a second auxiliary amplifier (144, 844), coupled to the first auxiliary amplifier (142, 842);
        a first resistor, coupled between an input terminal and an output terminal of the second auxiliary amplifier (144, 844); and
        a second resistor, coupled between an output terminal of the first auxiliary amplifier (142, 842) and a ground voltage.

2. The multi-stage amplifier (100, 800) of claim 1, wherein the input terminal of the first auxiliary amplifier (142, 842) is coupled to the input terminal of the second auxiliary amplifier (144, 844), and the output terminal of the second auxiliary amplifier (144, 844) is coupled to the output terminal of the one of the plurality of amplifier stages (110, 120, 130, 810, 820, 830).

3. The multi-stage amplifier (100, 800) of claim 1, wherein the first auxiliary amplifier (142, 842) comprises at least an N-type Metal Oxide Semiconductor Field Effect Transistor, MOSFET, or a P-type MOSFET.

4. The multi-stage amplifier (100, 800) of claim 3, wherein the second auxiliary amplifier (144, 844) comprises at least an N-type MOSFET or a P-type MOSFET.

5. The multi-stage amplifier (100, 800) of claim 1, wherein the plurality of amplifier stages (110, 120, 130, 810, 820, 830) comprise:

    a first amplifier stage (110, 810), configured to receive an input signal to generate a first signal;
    a second amplifier stage (120, 820), configured to receive the first signal to generate a second signal; and

a third amplifier stage (130, 830);
wherein the compensation circuit (140, 840) generates a third signal according to the second signal, wherein the third signal is inputted to the third amplifier stage (130, 830) .

**6.** The multi-stage amplifier (100, 800) of claim 5, wherein the input terminal of the first auxiliary amplifier (142, 842) is coupled to the input terminal of the second auxiliary amplifier (144, 844), and the output terminal of the second auxiliary amplifier (144, 844) is coupled to an output terminal of the second amplifier stage (120, 820); and the compensation circuit (140, 840) further comprises:
a third auxiliary amplifier (146), configured to receive the second signal to generate the third signal.

**7.** The multi-stage amplifier (100, 800) of claim 1, wherein the plurality of amplifier stages comprise:

a first amplifier stage (110, 810), configured to receive an input signal to generate a first signal;
a second amplifier stage (120, 820), configured to receive the first signal to generate a second signal; and
a third amplifier stage (130, 830), configured to receive the second signal to generate an output signal;
wherein the compensation circuit (140, 840) is coupled to an output terminal of the first amplifier stage (110, 810).

**8.** The multi-stage amplifier (100, 800) of claim 7, wherein the input terminal of the first auxiliary amplifier (142, 842) is coupled to the input terminal of the second auxiliary amplifier (144, 844), and the output terminal of the second auxiliary amplifier (144, 844) is coupled to the output terminal of the first amplifier stage (110, 810).

**9.** The multi-stage amplifier (100, 800) according to any one of the preceding claims, wherein the multi-stage amplifier (100, 800) is an audio amplifier configured to receive an audio signal.

FIG. 1

EP 4 439 979 A1

$$P1 = \frac{Gmb1}{(Gma+Gmb1)*Ra*Caz+Caz+Cpb}$$

$$P2 = \frac{1}{2\pi} * \frac{(Gma+Gmb1)*Ra*Caz+Caz+Cpb}{Caz*Cpb*(Gma*Ra*Raz+Ra+Raz)}$$

$$Z1 = \frac{1}{Caz*(Ra+Raz+Gma*Ra*Raz)}$$

FIG. 2

Gain (dB)

HiFi mode

LP mode

Frequency

Phase (°)

Frequency

Phase dip due to Zobel network

Conventional multi-stage amplifier
- - - - - without compensation circuit 140
——— with compensation circuit 140

FIG. 3

EP 4 439 979 A1

FIG. 4

EP 4 439 979 A1

FIG. 5

FIG. 6

FIG. 7

EP 4 439 979 A1

FIG. 8

Europäisches
Patentamt

European
Patent Office

Office européen
des brevets

# EUROPEAN SEARCH REPORT

Application Number

EP 24 16 3199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 208 206 B1 (LEUNG KA NANG [HK] ET AL) 27 March 2001 (2001-03-27) * column 1 - column 5; figures 1-9 * | 1-9 | INV. H03F1/14 H03F3/187 H03F3/21 |
| A | ZUSHU YAN ET AL: "A 0.016-mm $^{2}$ 144-$\mu$ W Three-Stage Amplifier Capable of Driving 1-to-15 nF Capacitive Load With $>$ 0.95-MHz GBW", IEEE JOURNAL OF SOLID-STATE CIRCUITS, IEEE, USA, vol. 48, no. 2, 1 February 2013 (2013-02-01), pages 527-540, XP011489702, ISSN: 0018-9200, DOI: 10.1109/JSSC.2012.2229070 * paragraph [000I] - paragraph [00VI]; figures 1-14 * | 1-9 | |
| A | SHIN HONGSEOK ET AL: "An Energy-Efficient Three-Stage Amplifier Achieving a High Unity-Gain Bandwidth for Large Capacitive Loads Without Using a Compensation Zero", IEEE SOLID-STATE CIRCUITS LETTERS, IEEE, vol. 3, 6 November 2020 (2020-11-06), pages 530-533, XP011823461, DOI: 10.1109/LSSC.2020.3036496 [retrieved on 2020-12-02] * paragraph [000I] - paragraph [00IV]; figures 1-9 * | 1-9 | TECHNICAL FIELDS SEARCHED (IPC) H03F |
| A | EP 3 745 590 A1 (MEDIATEK INC [TW]) 2 December 2020 (2020-12-02) * paragraph [0002] - paragraph [0026]; figures 1-8 * | 1-9 | |

The present search report has been drawn up for all claims

| Place of search | Date of completion of the search | Examiner |
|---|---|---|
| The Hague | 30 July 2024 | Rafflenbeul, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 4 439 979 A1

**ANNEX TO THE EUROPEAN SEARCH REPORT
ON EUROPEAN PATENT APPLICATION NO.**

EP 24 16 3199

This annex lists the patent family members relating to the patent documents cited in the above-mentioned European search report.
The members are as contained in the European Patent Office EDP file on
The European Patent Office is in no way liable for these particulars which are merely given for the purpose of information.

30-07-2024

| Patent document cited in search report | | Publication date | Patent family member(s) | | Publication date |
|---|---|---|---|---|---|
| US 6208206 | B1 | 27-03-2001 | NONE | | |
| EP 3745590 | A1 | 02-12-2020 | CN | 112019177 A | 01-12-2020 |
| | | | EP | 3745590 A1 | 02-12-2020 |
| | | | TW | 202046635 A | 16-12-2020 |
| | | | US | 2020382072 A1 | 03-12-2020 |

For more details about this annex : see Official Journal of the European Patent Office, No. 12/82

EPO FORM P0459

**EP 4 439 979 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63489790